# EUROPEAN PATENT SPECIFICATION

(11) **EP 3 511 988 B1**
(45) Date of publication and mention of the grant of the patent: **01.12.2021**
(21) Application number: 19151957.8
(22) Date of filing: 15.01.2019
(51) Int. Cl.: H01L 29/78, H01L 29/739, H01L 21/02

(54) **SEMICONDUCTOR ELECTRONIC DEVICE WITH TRENCH GATE AND MANUFACTURING METHOD THEREOF**
ELEKTRONISCHES HALBLEITERBAUELEMENT MIT TRENCH-GATE UND HERSTELLUNGSVERFAHREN DAFÜR
DISPOSITIF ÉLECTRONIQUE À SEMICONDUCTEUR AVEC GRILLE À TRANCHÉE ET SON PROCÉDÉ DE FABRICATION

(30) Priority: 15.01.2018 IT 201800000928
(43) Date of publication of application: 17.07.2019
(73) Proprietor: STMicroelectronics S.r.l., 20864 Agrate Brianza (MB) (IT)
(72) Inventor: PATTI, Davide Giuseppe, 95030 MASCALUCIA (CT) (IT); SAMBI, Marco, 20010 CORNAREDO (MI) (IT); TOIA, Fabrizio Fausto Renzo, 21052 BUSTO ARSIZIO (VA) (IT); MARIANI, Simone Dario, 20854 VEDANO AL LAMBRO (MB) (IT); PIZZI, Elisabetta, 20812 LIMBIATE (MB) (IT); BARILLARO, Giuseppe, 56121 PISA (IT)
(74) Representative: Bertolotto, Simone

(56) References cited:
- EP-A1- 0 205 639
- WO-A1-2004/055883
- US-A1- 2015 333 140
- R. HERINO: "Porosity and Pore Size Distributions of Porous Silicon Layers", JOURNAL OF THE ELECTROCHEMICAL SOCIETY, vol. 134, no. 8, 1 January 1987 (1987-01-01), page 1994, XP055503498, ISSN: 0013-4651, DOI: 10.1149/1.2100805

## Description

The present invention relates to a semiconductor electronic device with trench gate and to a method for manufacturing the semiconductor electronic device with trench gate.

Vertical-conduction power MOSFETs are known that have a buried-gate region or trench-gate region.

For instance, the patent document No. US 2015/0206968 describes a vertical-channel LDMOS semiconductor device, in which a gate trench extends in depth in a semiconductor body and comprises a conductive region, of doped polysilicon, surrounded and electrically insulated from the semiconductor body by a dielectric region (made, for example, of silicon oxide or silicon nitride).

The dielectric region may be formed by a process of deposition, for example liquid-phase deposition (LPD), or else by thermal growth of an oxide. Both of the processes present some intrinsic limits. For instance, deposition of a dielectric layer may cause crystallographic interface stresses that may jeopardise electrical operation of the device (e.g., generating traps for the charge carriers), whereas thermal growth requires the use of structures for protecting the surface regions in which growth of a thermal oxide is undesirable or counterproductive.

Patent document WO 2004/055883 A1 relates to the method of manufacture of a semiconductor device incorporating a trench, particularly a trench MOSFET (metal oxide semiconductor field effect transistor). According to the method disclosed in WO 2004/055883 A1, a plug of porous silicon is formed at a bottom of a trench in a substrate. The porous silicon is formed from the silicon at the bottom of the trench by etching using a dry etch. A thermal oxidation is then carried out to oxidize the porous silicon to form an oxide plug in the trench. Furthermore, a gate oxide is formed on sidewalls of the trench. The trench is filled with polysilicon acting as a gate in a finished device. The gate is in direct contact with the oxide plug.

Patent document US2015/333140 relates to a semiconductor structure and a method of forming the same, and more particularly to a trench gate metal-oxide-semiconductor (MOS) structure and a method of forming the same.

However, the above-mentioned issues remain unsolved.

Consequently, there is the need for a process for manufacturing an electronic device with trench gate that will overcome the disadvantages of the prior art.

According to the present invention, a semiconductor electronic device and a method for manufacturing the semiconductor electronic device are provided, as defined in the annexed claims.

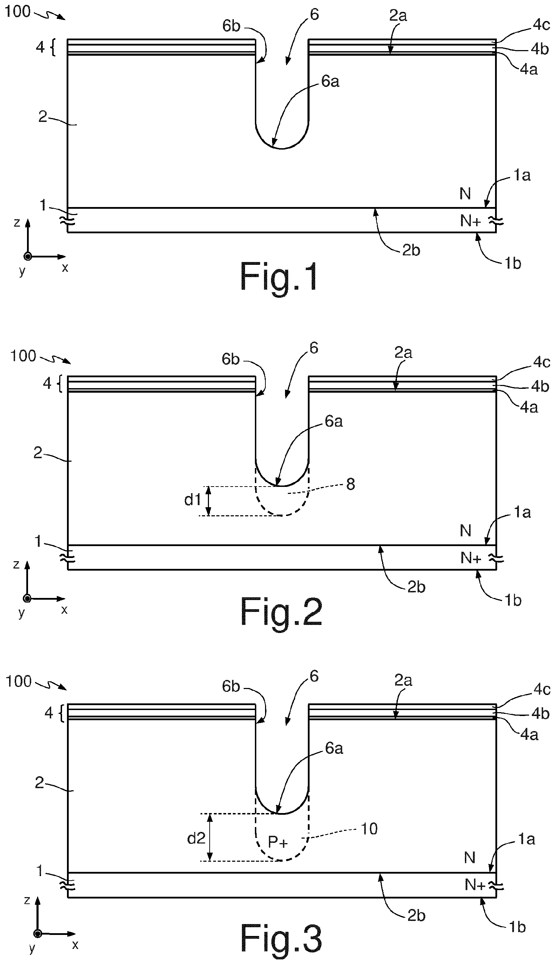

For a better understanding of the present invention, preferred embodiments thereof are now described, purely by way of non-limiting example, with reference to the attached drawings, wherein Figures 1-13 illustrate, in lateral sectional view, manufacturing steps for the production of a semiconductor electronic device with trench region, according to an embodiment of the present invention.

According to the present invention as defined in claim 1, a power device is provided, in particular a MOS transistor with source electrode on a front side of the device, drain electrode on a back side of the device, and trench gate, which extends from the front side towards the back side.

The steps for manufacturing the electronic device according to the present invention are described in the following, with reference to Figures 1-13. Figures 1-13 illustrate the electronic device in lateral sectional view, in a system of spatial coordinates defined by mutually orthogonal axes X, Y, and Z.

In particular, the present disclosure describes exclusively the manufacturing steps of interest for the invention (i.e., regarding construction of a trench gate provided with an internal insulation region). Further elements of the electronic device (e.g., edge regions or other structures), which are of a per se known type, are not described and illustrated here in the figures.

Figure 1 illustrates a wafer 100 comprising a substrate 1, in particular of monocrystalline silicon, having a first conductivity (here, of an N type) and a first doping concentration (e.g., higher than 10¹⁹ at./cm³). The substrate 1 is delimited on a first side 1a and on a second side 1b opposite to one another along the axis Z.

On the substrate 1, a structural layer or region 2 is formed, for example by epitaxial growth of silicon, having the first conductivity (N) and a concentration of dopants lower than that of the substrate 1 (e.g., comprised between 1·10¹⁵ and 5·10¹⁶ ions/cm³). The structural region 2 has a thickness, along Z, that is chosen according to the need on the basis of the voltage class in which the electronic device is to operate, and is, for example, comprised approximately between 1.5 µm and 100 µm.

The structural region 2 is delimited by a first side 2a and a second side 2b opposite to one another in the direction Z. The second side 2b of the structural region 2 coincides with the first side 1a of the substrate 1.

According to alternative embodiments (not illustrated), one or more further structural regions, which are, for example, grown epitaxially and are similar to the structural region 2, may be formed between the first side 1a of the substrate 1 and the second side 2b of the structural region 2.

On the first side 2a of the structural layer 2, a mask multilayer 4 is then formed, which includes: a first mask layer 4a, in contact with the first side 2a, made, for example, of silicon oxide grown via thermal oxidation with a thickness comprised between 5 nm and 100 nm; a second mask layer 4b, immediately on top of the first mask layer 4a, made, for example, of silicon nitride with a thickness comprised between 10 nm and 1 µm; and a third mask layer 4c, immediately on top of the second mask layer 4b, made, for example, of TEOS or photoresist with a thickness comprised between 10 nm and 10 µm. The first mask layer 4a has the function of forming an interface between the structural layer 2, of silicon, and the second mask layer 4b, of silicon nitride, in order to prevent mechanical stress induced by silicon nitride and prevent nitriding of the surface of the silicon itself, which jeopardises operation of the device. The second mask layer 4b forms a hard mask for a subsequent step of etching of the structural layer 2. The third mask layer 4c forms a further hard mask for the step of etching of the structural layer 2.

By photolithographic technique, the mask multilayer 4 is removed in regions of the wafer 100 where the trench gate is to be formed. Then etching is carried out, in particular of a dry type, for example RIE, for selective removal of portions of the structural layer 2 exposed through the mask multilayer 4 and so as to form a trench 6 delimited by a bottom wall 6a and side walls 6b. The trench 6 has a depth, measured starting from the first side 2a of the structural layer 2 comprised, for example, between 1 and 2 µm.

In top plan view, in the plane XY, the trench 6 may be strip-shaped, with main extension along the axis Y ranging from a few microns to a few millimetres, and a width, along the axis X, comprised between 0.5 µm and 1.5 µm. Other layouts may be envisaged for the trench 6; for example, it may have, once again in view in the plane XY, a circular shape with a diameter comprised between 0.5 µm and 1.5 µm, or some other shape, for example, generically polygonal.

Next (Figure 2), at the bottom wall 6a of the trench 6, it is formed an implanted region 8 having a second conductivity type (here, a conductivity of P+ type), for example by a step of ion implantation of boron. More in particular, a plurality of successive implantations (e.g., from one to three implantations) are carried out, each at a respective implantation energy but with the same dose of dopant atoms (or respective doses chosen in a limited range, for example not more than one order of magnitude). The implanted region 8 is thus formed, which extends from the bottom wall 6a of the trench 6 for a depth d₁, measured starting from the bottom wall 6a, of a few microns. The implantation dose is, by way of example, comprised between 5·10¹⁴ and 5·10¹⁵ at./cm^{3,} and the implantation energies are, by way of example, comprised between 100 keV and 1000 keV.

A subsequent rapid thermal process at a high temperature (also known as RTA or RTP), for example, comprised between 900°C and 1150°C for 30 seconds, activates the dopants of the implanted region 8 and enables minimal diffusion thereof in the structural layer 2, in particular in depth. A doped region 10 is thus formed (Figure 3), having an extension d₂, measured starting from the bottom wall 6a, just a little greater than d₁ and of a few microns.

As an alternative to RTA or RTP, it is possible to carry out an oxidation process of an ISSG type or, once again alternatively, an oxidation (of a wet or dry type) in an oven.

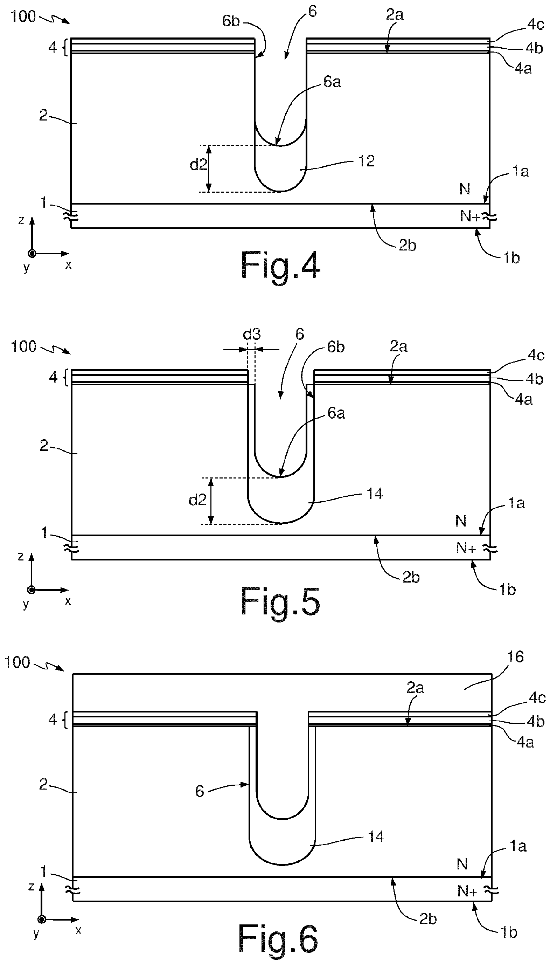

Next (Figure 4), the doped region 10 is converted into a porous-silicon region 12.

In general, the structure of porous silicon, from a morphological standpoint, presents as an interconnected network of pores. The size, direction, position, and depth of the pores depend upon parameters set during formation thereof, as well as upon the conductivity type of the region in which the porous silicon is formed.

In fact, as is known, on the basis of the density and type of doping of the region in which the porous silicon is formed, the morphology of porous silicon differs. In the case of silicon of a P type, the mean diameter of the pores ranges between 1 nm and 100 nm, and the structure obtained is branched, highly interconnected, and homogeneous. As the dose of dopant for formation of the doped region 10 increases, the diameter of the pores and the distance between them increase. The present applicant has noted that the implantation dose affects both the rate of growth of porous silicon and the degree of porosity (in particular, the higher the dose of dopants, the greater the volume of the voids at the expense of the volume of full silicon).

The system used, for anodic etching of silicon, typically comprises a cell with three electrodes, one of which is represented by the crystalline-silicon wafer 100, which contains an aqueous electrolytic solution.

The wafer 100 is located at a positive (anode) potential with respect to the electrolytic solution; the front side of the wafer 100 (having the trench 6) is arranged directly in contact with the electrolytic solution. The electrolytic solution is typically made up of HF, de-ionised water, and ethanol. Other compounds may be used to improve wettability of the silicon surface exposed to etching, reducing the formation of hydrogen bubbles that are formed, during the electrochemical reaction, at the electrodes.

The characteristics of the porous-silicon region 12 that is to be formed (size of the pores, direction, porosity) depend markedly upon the parameters set during the etching step, in particular upon:
- the composition of the electrolyte in solution, and thus the percentage of HF present in solution, chosen between 5% and 48%;
- the value of the anodisation current, chosen between 5 and 1000 mA/cm²;
- the etching time, chosen between 5 and 500 s;
- the resistivity of the substrate (i.e., doping, already discussed previously); and
- the temperature of the solution during the process, here carried out at room temperature.

The reaction of dissolution occurs immediately for the silicon regions of a P type, which may be anodised in the dark. Instead, for N-type silicon the presence of lighting is necessary. It is thus possible to form the porous-silicon region selectively in the implanted region 10. The holes are necessary for the chemical reaction of dissolution of the crystalline silicon, which takes place at the interface between the silicon and the electrolytic solution.

Then, the step of Figure 5 is carried out, in which the porous-silicon region 12 is transformed into a dielectric region 14, in particular of silicon oxide.

The porous nature of the porous-silicon region 12 enables transformation thereof with extreme ease into silicon oxide (also known as PSO, Porous Silicon Oxide). Porous silicon presents, in fact, a high oxidation rate at low temperatures, an oxidation rate much higher than that of monocrystalline silicon. This is basically due to an extensive surface exposed to the process, which enables layers of porous silicon oxide to be obtained with a large thickness in a relatively short time.

For this purpose, a process of oxidation is carried out in a furnace at a high temperature (e.g., a rapid thermal process, at a temperature of 1000°C with a temperature ascending ramp in an interval of 5-30 s, maintenance at the temperature in an interval of 1-10 min, and decrease to room temperature with a descending ramp down to room temperature in an interval of 30-60 s). This rapid-thermal-oxidation (RTO) process transforms the porous-silicon region 12 into the dielectric region 14, of low-density silicon oxide.

The thermal-oxidation process mentioned here likewise causes formation of an oxide layer on the side walls 6b of the trench 6, with a thickness d₃, measured along the axis X, of a few nanometers. Consequently, the internal free volume of the trench 6 is reduced.

This is followed (Figure 6) by a step of formation, for example via CVD, of a layer of dielectric material 16 having a density higher than the density of the dielectric region 14, made, for example, of TEOS (alternatively, BPSG, USG, and SOG may be chosen), until the trench 6 is completely filled. The layer of dielectric material 16 fills the trench 6 and likewise deposits on the wafer 100.

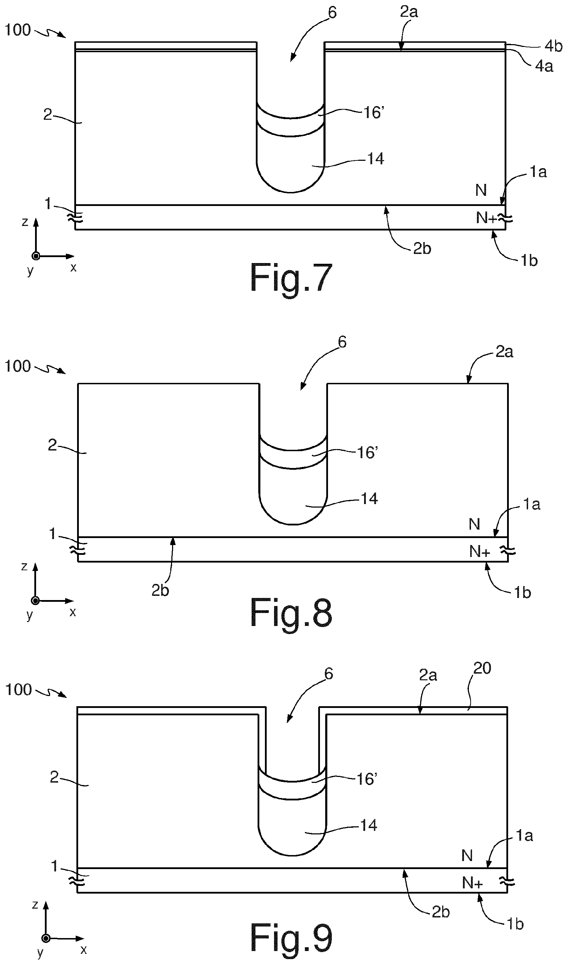

Next (Figure 7), anisotropic plasma chemical etching is carried out for progressive removal of the layer of dielectric material 16 and of the third mask layer 4c (both of which are of TEOS in this example), as far as the second mask layer 4b, here of Si₃N₄, which functions as etch-stop layer. A portion 16' of the layer of dielectric material 16 remains inside the trench 6, on the bottom side 6a, to cover completely, and protect, the dielectric region 14.

Optionally, a further etch in HF (wet etch) is made to complete removal of any possible oxide still present on the inner walls 6b of the trench 6.

Then (Figure 8), two selective chemical etches are made for respective removal of the second mask layer 4b and the first underlying mask layer 4a, until the first side 2a of the structural layer 2 is exposed.

There then follows (Figure 9) a step of formation, for example by thermal oxidation, of a gate-oxide layer 20 on the side walls 6b of the trench 6 (i.e., at the interface with the structural layer 2 exposed inside the trench 6) and on the first side 2a of the structural layer 2. The gate-oxide layer 20 has, for example, a thickness comprised between 10 and 50 nm.

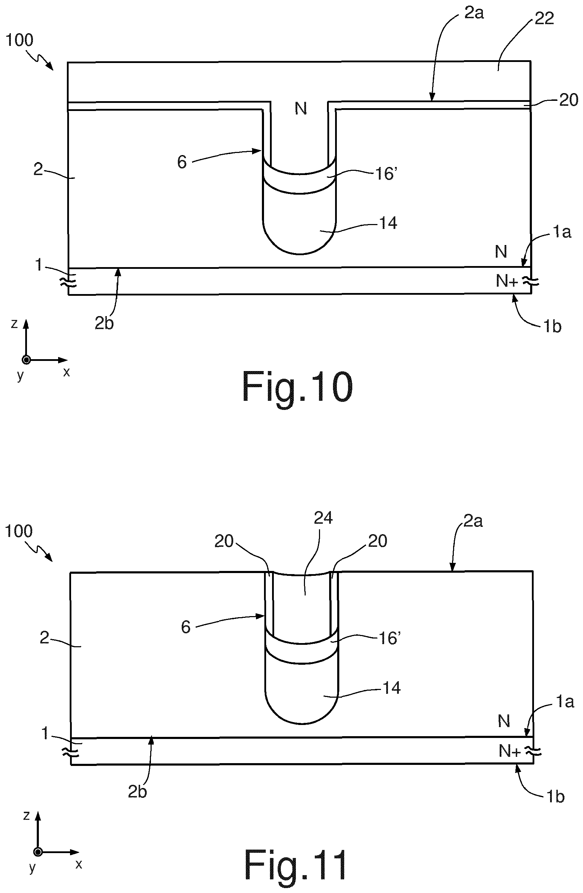

Next (Figure 10), a layer of doped polysilicon 22, having the first conductivity type (N), and a doping level comprised between 10¹⁷ at./cm³ and 10¹⁹ at./cm³ is deposited, and (Figure 11), a subsequent etching step is carried out for removal of the layer of doped polysilicon 22 from the front of the wafer 100 except for the trench 6. In other words, a trench conductive region 24, here of doped polysilicon N, extends in the trench 6 on the portion 16', filling the trench 6 completely.

In a different embodiment, not illustrated, the trench conductive region 24 fills the trench 6 only partially, stopping at a distance from the first side 2a, measured along Z, comprised between 100 nm and the depth of the trench 6.

The trench conductive region 24 forms, at least in part, the gate electrode, which is electrically insulated from the structural layer 2 by the gate-oxide layer 20 (gate dielectric).

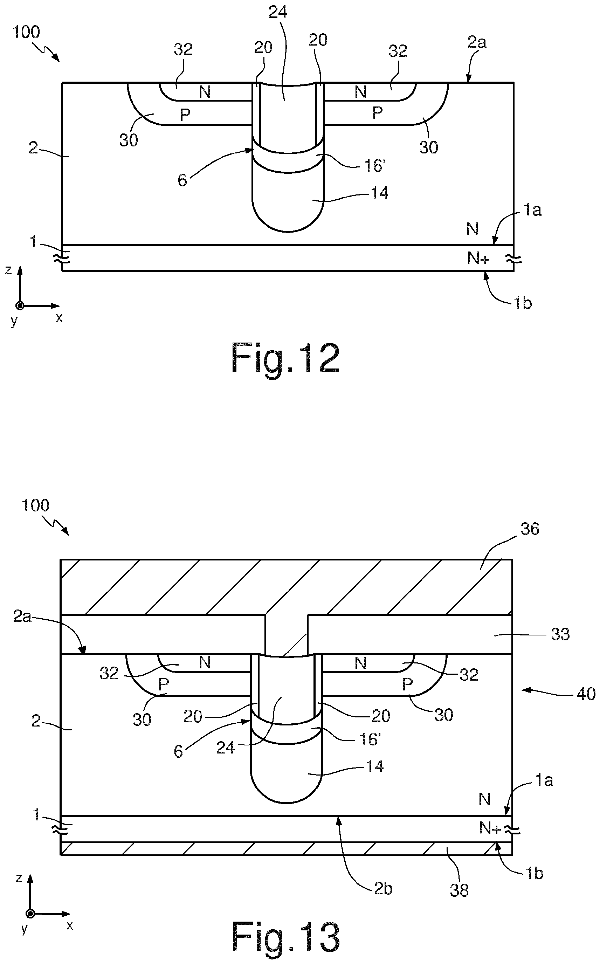

Then, with reference to Figure 12, formed with known techniques of implantation of dopant species and diffusion are a body region 30, having the second conductivity (P), and one or more source regions 32, having the first conductivity (N), which are self-aligned to the trench 6 (here filled as described previously) .

Processing of the wafer 100 may then continue (Figure 13) with deposition of pre-metallization dielectric 33, etching of the latter for opening electrical contacts by photolithography so as to reach and expose respective surface portions of the gate electrode 24 and of the source regions 32, respective depositions of one or more metal layers that contact the gate electrode 24 and the source regions 32, and photolithographic definition of said metal layers 36 for completing formation of the source and gate electrodes (the cross-sectional view of Figure 13 represents exclusively the gate metallization 36). A further deposition on the back of the wafer (on the second side 1b of the substrate 1) enables formation of a drain metallization 38.

In detail, the body region 30 is formed by implanting dopant species of a P type in order to obtain a doping level comprised approximately between 1·10¹⁷ ions/cm³ and 5·10¹⁷ ions/cm³. In greater detail, the body region 30 is formed in the structural region 2 for a depth in the direction Z comprised, for example, approximately between 0.5 µm and 1.0 µm.

The source regions 32 extend in the body region 30, facing the first side 2a of the structural region 2, for a depth in the direction Z comprised, for example, approximately between 100 nm and 150 nm. The source regions 32 each have a doping level, for example, of approximately 1·10²⁰ ions/cm³, and extend in top plan view, alongside the gate electrode 24, separated from the latter by the dielectric 20.

The gate and source metallizations 36 are formed by depositing conductive material on the wafer 100, in particular metal such as aluminium. Likewise, also the drain metallization 38 is formed by a step of deposition of conductive material, in particular metal, on the back of the wafer 100, thus completing formation of the drain terminal.

A vertical-conduction electronic device (here, a power MOSFET) 40 is thus formed. Thus, in use, an electric current may flow vertically (along Z) from the source regions 32 to the drain metallization 38, through the structural region 2 and the substrate 1.

The electronic device 40 according to the present invention is, by way of example, one of the following: a vertical-conduction power MOS transistor, a power IGBT, or an MCT (MOS-Controlled Thyristor). Other applications may be envisaged, according to need.

From an examination of the characteristics of the disclosure provided according to the present invention the advantages that it affords are evident.

In particular, formation of the dielectric region 14 by oxidation of porous silicon is fast and far from costly, and considerably simplifies the manufacturing processes according to the prior art.

Further, said dielectric region 14 has a low value of dielectric constant, which enables reduction of the parasitic capacitance between the conductive polysilicon region 24 (gate) and the portion of the structural layer 2 that extends underneath the dielectric region 14.

The technical solution according to the present invention is likewise reliable, in so far as porous silicon oxide does not generate a significant stress at the interface with the structural layer 2. Consequently, no significant drifts of operating parameters or structural damages to the electronic device thus manufactured are noted during its service life.

Finally, the process according to the present invention is flexible, in so far as the depth that may be reached by the dielectric region 14 may be adjusted during the step of implantation and diffusion of the implanted region 10.

Finally, it is clear that modifications and variations may be made to what has been described and illustrated herein, without thereby departing from the scope of the present invention, as defined in the annexed claims.

In particular, the present invention may be adapted for manufacturing an electronic device different from what is illustrated in the figures (for example, comprising a different configuration of the body region and/or of the source regions).

## Claims

1. A semiconductor electronic device (40) comprising:
- a semiconductor body (1, 2), having a first conductivity, delimited by a first side (2a) and a second side (1b) opposite to one another along an axis (Z);
- a body region (30), having a second conductivity opposite to the first conductivity, in the semiconductor body (1, 2) facing the first side (2a);
- a source terminal (32), having the first conductivity, extending at least in part in the body region (30) ;
- a drain terminal (38), having the first conductivity, extending at the second side (1b) of the semiconductor body (1, 2); and
- a trench gate (6, 14, 16', 24), which extends in the semiconductor body (1, 2) from the first side (2a) towards the second side (1b), through the body region (30) and the source region (32),
wherein said trench gate (6, 14, 16', 24) includes a dielectric region (14) of porous silicon oxide buried in the semiconductor body (1, 2), and a gate conductive region (24) extending between the dielectric region (14) of porous silicon oxide and said first side (2a),
wherein a gate dielectric (20) extends between the gate conductive region (24) and the semiconductor body (1, 2),
**characterized in that** said trench gate (6, 14, 16', 24) , in addition to the gate dielectric (20), further includes a protection region (16') between the dielectric region (14) of porous silicon oxide and the gate conductive region (24), designed for separating the dielectric region (14) of porous silicon oxide from the gate conductive region (24),
said protection region (16') being of a dielectric material or of an electrically insulating material, and has a density higher than the density of the dielectric region (14) .

2. The device according to claim 1, wherein the gate conductive region (24) is of doped polysilicon.

3. The device according to claim 1 or claim 2, chosen in the group comprising: a vertical-conduction power MOS transistor, a power IGBT, and an MCT.

4. A method for manufacturing a semiconductor electronic device (40), comprising the steps of:
- forming, at a first side (2a) of a semiconductor body (1, 2) having a first conductivity (N), a body region (30) having a second conductivity (P) opposite to the first conductivity;
- forming, at least in part in the body region (30), a source terminal (32) having the first conductivity (N);
- forming, at a second side (1b), opposite to the first side (2a), of the semiconductor body (1, 2), a drain terminal (38); and
- forming a trench (6) at the first side (2a) of the semiconductor body (1, 2) and through the body region (30) and the source region (32);
forming a porous-silicon region (12) in the semiconductor body (1, 2) at a bottom side (6a) of the trench (6) and in spatial continuation of the trench (6); and
oxidising the porous-silicon region (12), to form a dielectric region (14) of porous silicon oxide,
wherein the step of forming the porous-silicon region (12) comprises:
implanting dopant species that have the second conductivity (P) in the semiconductor body (1, 2), at the bottom side (6a) of the trench (6);
thermally activating said implanted dopant species, to form an implanted region (10); and
carrying out an electrochemical reaction designed to transform said implanted region (10) into the porous-silicon region (12),
the method further comprising the steps of:
forming a protection region (16'), which has a density higher than the density of the dielectric region (14), in the trench (6) on the dielectric region (14) of porous silicon oxide, wherein said protection region (16') is of a dielectric material or of an electrically insulating material;
forming a gate dielectric (20) on internal side walls (6b) of the trench (6);
forming a gate conductive region (24) in the trench (6) on the protection region (16'), so that the gate conductive region (24) is separated from the dielectric region (14) of porous silicon oxide by the protection region (16') and so that the gate dielectric (20) extends between the gate conductive region (24) and the semiconductor body (1, 2).

5. The method according to claim 4, wherein said step of implanting dopant species includes carrying out a plurality of successive implantations with different implantation energies in the range comprised between 100 keV and 1000 keV and with the same implantation dose comprised between 5·10¹⁴ and 5·10¹⁵ at./cm³.

6. The method according to claim 4 or claim 5, wherein the step of carrying out the electrochemical reaction comprises the substeps of:
inserting said semiconductor body (1, 2) in an aqueous electrolytic solution that includes hydrofluoric acid in a percentage comprised between 5% and 48%;
maintaining the electrolytic solution at room temperature; and
applying an anodization current having a value comprised between 5 mA/cm² and 1000 mA/cm².

7. The method according to any one of claims 4 to 6, wherein the step of forming the porous-silicon region (12) further comprises carrying out a thermal-oxidation process at a temperature comprised between 900°C and 1050°C, with an ascending ramp in temperature in an interval of 5 to 60 s, and maintenance of constant temperature in an interval of 1 to 10 min.

8. The method according to any one of claims 4 to 7, wherein the step of forming the protection region (16') comprises depositing insulating material in the trench (6).

## Patentansprüche

1. Elektronische Halbleitervorrichtung (40), umfassend:
- einen Halbleiterkörper (1, 2), der eine erste Leitfähigkeit aufweist, der begrenzt wird von einer ersten Seite (2a) und einer zweiten Seite (1b), die entlang einer Achse (Z) einander gegenüberliegen;
- einen Körperbereich (30), der eine zweite Leitfähigkeit, die der ersten Leitfähigkeit entgegengesetzt ist, in dem Halbleiterkörper (1, 2) aufweist, der der ersten Seite (2a) zugewandt ist;
- eine Source-Klemme (32), die die erste Leitfähigkeit aufweist, die sich wenigstens teilweise in dem Körperbereich (30) erstreckt;
- eine Drain-Klemme (38), die die erste Leitfähigkeit aufweist, die sich an der zweiten Seite (1b) des Halbleiterkörpers (1, 2) erstreckt; und
- ein Trench-Gate (6, 14, 16', 24), das sich in dem Halbleiterkörper (1, 2) von der ersten Seite (2a) zu der zweiten Seite (1b) durch den Körperbereich (30) und den Source-Bereich (32) erstreckt,
wobei das Trench-Gate (6, 14, 16', 24) einen dielektrischen Bereich (14) aus porösem Siliziumoxid, der in dem Halbleiterkörper (1, 2) verborgen ist, und einen leitfähigen Gate-Bereich (24) umfasst, der sich zwischen dem dielektrischen Bereich (14) aus porösem Siliziumoxid und der ersten Seite (2a) erstreckt,
wobei sich ein Gate-Dielektrikum (20) zwischen dem leitfähigen Gate-Bereich (24) und dem Halbleiterkörper (1, 2) erstreckt,
**dadurch gekennzeichnet, dass** das Trench-Gate (6, 14, 16', 24) zusätzlich zum Gate-Dielektrikum (20) weiter einen Schutzbereich (16') zwischen dem dielektrischen Bereich (14) aus porösem Siliziumoxid und dem leitfähigen Gate-Bereich (24) umfasst, der ausgestaltet ist, den dielektrischen Bereich (14) aus porösem Siliziumoxid von dem leitfähigen Gate-Bereich (24) zu trennen,
wobei der Schutzbereich (16') aus einem dielektrischen Material oder aus einem elektrisch isolierenden Material hergestellt ist und eine Dichte aufweist, die höher ist als die Dichte des dielektrischen Bereichs (14).

2. Vorrichtung nach Anspruch 1, wobei der leitfähige Gate-Bereich (24) aus dotiertem Polysilizium hergestellt ist.

3. Vorrichtung nach Anspruch 1 oder Anspruch 2, ausgewählt in der Gruppe, umfassend: einen vertikal leitenden Leistungs-MOS-Transistor, einen Leistungs-IGBT und einen MCT.

4. Verfahren zur Herstellung einer elektronischen Halbleitervorrichtung (40), umfassend folgende Schritte:
- Bilden, an einer ersten Seite (2a) eines Halbleiterkörpers (1, 2), der eine erste Leitfähigkeit (N) aufweist, eines Körperbereichs (30), der eine zweite Leitfähigkeit (P) aufweist, die der ersten Leitfähigkeit entgegengesetzt ist;
- Bilden, wenigstens teilweise in dem Körperbereich (30), einer Source-Klemme (32), die die erste Leitfähigkeit (N) aufweist;
- Bilden, an einer zweiten Seite (1b) des Halbleiterkörpers (1, 2), die der ersten Seite (2a) gegenüberliegt, einer Drain-Klemme (38); und
- Bilden eines Trenchs (6) an der ersten Seite (2a) des Halbleiterkörpers (1, 2) und durch den Körperbereich (30) und den Source-Bereich (32);
Bilden eines porösen Silizium-Bereichs (12) in dem Halbleiterkörper (1, 2) an einer Unterseite (6a) des Trenchs (6) und in räumlicher Kontinuität des Trenchs (6); und
Oxidieren des porösen Silizium-Bereichs (12), um einen dielektrischen Bereich (14) aus porösem Siliziumoxid zu bilden,
wobei der Schritt des Bildens des porösen Silizium-Bereichs (12) umfasst:
Implantieren von Dotierungsstoffen, welche die zweite Leitfähigkeit (P) aufweisen, in den Halbleiterkörper (1, 2) an der Unterseite (6a) des Trenchs (6);
thermisches Aktivieren der implantierten Dotierungsstoffe, um einen implantierten Bereich (10) zu bilden; und
Durchführen einer elektrochemischen Reaktion, die ausgestaltet ist, den implantierten Bereich (10) in den porösen Silizium-Bereich (12) umzuformen,
wobei das Verfahren weiter folgende Schritte umfasst:
Bilden eines Schutzbereichs (16'), der eine Dichte aufweist, die höher ist als die Dichte des dielektrischen Bereichs (14), in dem Trench (6) auf dem dielektrischen Bereich (14) aus porösem Siliziumoxid, wobei der Schutzbereich (16') aus einem dielektrischen Material oder aus einem elektrisch isolierenden Material hergestellt ist; Bilden eines Gate-Dielektrikums (20) auf inneren Seitenwänden (6b) des Trenchs (6);
Bilden eines leitfähigen Gate-Bereichs (24) in dem Trench (6) auf dem Schutzbereich (16'), sodass der leitfähige Gate-Bereich (24) von dem dielektrischen Bereich (14) aus porösem Siliziumoxid durch den Schutzbereich (16') getrennt wird und sodass sich das Gate-Dielektrikum (20) zwischen dem leitfähigen Gate-Bereich (24) und dem Halbleiterkörper (1, 2) erstreckt.

5. Verfahren nach Anspruch 4, wobei der Schritt des Implantierens von Dotierungsstoffen das Durchführen einer Vielzahl von aufeinanderfolgenden Implantationen mit unterschiedlichen Implantationsenergien in dem Bereich zwischen 100 keV und 1000 keV und mit der gleichen Implantationsdosis zwischen 5·10¹⁴ und 5·10¹⁵ bei ./cm³ umfasst.

6. Verfahren nach Anspruch 4 oder Anspruch 5, wobei der Schritt des Durchführens der elektrochemischen Reaktion folgende Teilschritte umfasst:
Einführen des Halbleiterkörpers (1, 2) in eine wässrige Elektrolytlösung, die Flusssäure in einem Prozentanteil zwischen 5 % und 48 % umfasst;
Halten der Elektrolytlösung auf Raumtemperatur; und
Anlegen eines Anodisierungsstroms, der einen Wert zwischen 5 mA/cm² und 1000 mA/cm² aufweist.

7. Verfahren nach einem der Ansprüche 4 bis 6, wobei der Schritt des Bildens des porösen Silizium-Bereichs (12) weiter das Durchführen eines thermischen Oxidationsprozesses bei einer Temperatur zwischen 900°C und 1050°C umfasst, mit einer ansteigenden Temperaturrampe in einem Intervall von 5 bis 60 s, und Halten konstanter Temperatur in einem Intervall von 1 bis 10 min.

8. Verfahren nach einem der Ansprüche 4 bis 7, wobei der Schritt des Bildens des Schutzbereichs (16') das Aufbringen von isolierendem Material in dem Trench (6) umfasst.

## Revendications

1. Dispositif électronique à semi-conducteur (40) comprenant :
- un corps semi-conducteur (1, 2) ayant une première conductivité, délimité par un premier côté (2a) et un deuxième côté (1b) à l'opposé l'un de l'autre le long d'un axe (Z) ;
- une région de corps (30) ayant une deuxième conductivité opposée à la première conductivité, dans le corps semi-conducteur (1, 2) en face du premier côté (2a) ;
- une borne de source (32) ayant la première conductivité, s'étendant au moins en partie dans la région de corps (30) ;
- une borne de drain (38) ayant la première conductivité, s'étendant sur le deuxième côté (1b) du corps semi-conducteur (1, 2) ; et
- une grille à tranchée (6, 14, 16', 24) qui s'étend dans le corps semi-conducteur (1, 2) du premier côté (2a) vers le deuxième côté (1b), à travers la région de corps (30) et la région de source (32),
dans lequel ladite grille à tranchée (6, 14, 16', 24) comprend une région diélectrique (14) en oxyde de silicium poreux enfoui dans le corps semi-conducteur (1, 2), et une région conductrice de grille (24) s'étendant entre la région diélectrique (14) en oxyde de silicium poreux et ledit premier côté (2a),
dans lequel un diélectrique de grille (20) s'étend entre la région conductrice de grille (24) et le corps semi-conducteur (1, 2),
**caractérisé en ce que** ladite grille à tranchée (6, 14, 16', 24), en plus du diélectrique de grille (20), comprend une région de protection (16') entre la région diélectrique (14) en oxyde de silicium poreux et la région conductrice de grille (24), conçue pour séparer la région diélectrique (14) en oxyde de silicium poreux de la région conductrice de grille (24),
ladite région de protection (16') étant faite d'un matériau diélectrique ou d'un matériau électriquement isolant, et a une masse volumique supérieure à la masse volumique de la région diélectrique (14).

2. Dispositif selon la revendication 1, dans lequel la région conductrice de grille (24) est en polysilicium dopé.

3. Dispositif selon la revendication 1 ou 2, choisi dans le groupe comprenant : un transistor MOS de puissance à conduction verticale, un transistor IGBT de puissance et un thyristor MCT.

4. Procédé de fabrication d'un dispositif électronique à semi-conducteur (40), comprenant les étapes suivantes :
- former, sur un premier côté (2a) d'un corps semi-conducteur (1, 2) ayant une première conductivité (N), une région de corps (30) ayant une deuxième conductivité (P) opposée à la première conductivité ;
- former, au moins en partie dans la région de corps (30), une borne de source (32) ayant la première conductivité (N) ;
- former sur un deuxième côté (1b), opposé au premier côté (2a), du corps semi-conducteur (1, 2), une borne de drain (38) ; et
- former une tranchée (6) sur le premier côté (2a) du corps semi-conducteur (1, 2) et à travers la région de corps (30) et la région de source (32) ;
former une région de silicium poreux (12) dans le corps semi-conducteur (1, 2) dans un côté inférieur (6a) de la tranchée (6) et dans la continuité spatiale de la tranchée (6) ; et
oxyder la région de silicium poreux (12) pour former une région diélectrique (14) en oxyde de silicium poreux,
dans lequel l'étape de formation de la région de silicium poreux (12) comprend les opérations suivantes :
implanter une entité dopante qui a la deuxième conductivité (P) dans le corps semi-conducteur (1, 2), dans le côté inférieur (6a) de la tranchée (6) ;
activer thermiquement ladite entité dopante implantée, afin de former une région implantée (10) ; et
réaliser une réaction électrochimique conçue pour transformer ladite région implantée (10) en ladite région de silicium poreux (12),
le procédé comprenant en outre les étapes suivantes :
former une région de protection (16') qui a une masse volumique supérieure à la masse volumique de la région diélectrique (14), dans la tranchée (6) sur la région diélectrique (14) en oxyde de silicium poreux, ladite région de protection (16') étant faite d'un matériau diélectrique ou d'un matériau électriquement isolant ;
former un diélectrique de grille (20) sur des parois latérales internes (6b) de la tranchée (6) ;
former une région conductrice de grille (24) dans la tranchée (6) sur la région de protection (16'), de telle manière que la région conductrice de grille (24) est séparée de la région diélectrique (14) en oxyde de silicium poreux par la région de protection (16') et de telle manière que le diélectrique de grille (20) s'étend entre la région conductrice de grille (24) et le corps semi-conducteur (1, 2).

5. Procédé selon la revendication 4, dans lequel ladite étape d'implantation d'une entité dopante comprend l'exécution d'une pluralité d'implantations successives avec des énergies d'implantation différentes dans la plage comprise entre 100 keV et 1 000 keV et avec la même dose d'implantation comprise entre 5·10¹⁴ et 5·10¹⁵ at./cm³.

6. Procédé selon la revendication 4 ou 5, dans lequel l'étape de réalisation de la réaction électrochimique comprend les sous-étapes suivantes :
insérer ledit corps semi-conducteur (1, 2) dans une solution électrolytique aqueuse qui contient de l'acide fluorhydrique en un pourcentage compris entre 5 % et 48 % ;
maintenir la solution électrolytique à température ambiante ; et
appliquer un courant d'anodisation ayant une valeur comprise entre 5 mA/cm² et 1 000 mA/cm².

7. Procédé selon l'une quelconque des revendications 4 à 6, dans lequel l'étape de formation de la région de silicium poreux (12) comprend en outre l'exécution d'un processus d'oxydation thermique à une température comprise entre 900 °C et 1 050 °C, avec une rampe ascendante de température comprise dans un intervalle de 5 à 60 s, et le maintien d'une température constante sur un intervalle de 1 à 10 min.

8. Procédé selon l'une quelconque des revendications 4 à 7, dans lequel l'étape de formation de la région de protection (16') comprend le dépôt d'un matériau isolant dans la tranchée (6).
